# EUROPEAN PATENT SPECIFICATION

(11) **EP 3 029 744 B1**
(45) Date of publication and mention of the grant of the patent: **05.07.2017**
(21) Application number: 14761672.6
(22) Date of filing: 01.08.2014
(51) Int. Cl.: H01L 31/054, F24J 2/00, G02B 5/32

(54) **SOLAR MODULE COMPRISING HOLOGRAPHIC REFLECTING CONCENTRATING OPTICS**
SOLARMODUL MIT HOLOGRAPHISCHER REFLEKTIERENDER KONZENTRIENDER OPTIK
PANNEAU SOLAIRE TRIDIMENSIONNEL THERMIQUE OU PHOTOVOLTAÏQUE À HOLOGRAPHIE INCORPORÉE

(30) Priority: 01.08.2013 ES 201331199
(43) Date of publication of application: 08.06.2016
(73) Proprietor: Instituto Holográfico Terrasun, S.L., 41927 Mairena de Aljarafe (Sevilla) (ES)
(72) Inventor: CALO LÓPEZ, Antonio, E-11500 El Puerto de Santa María (Cádiz) (ES); VILLAMARÍN VILLEGAS, Ayalid, Mirlydeth, E-11500 El Puerto de Santa María (Cádiz) (ES); RODRÍGUEZ SAN SEGUNDO, Hugo, José, E-11500 El Puerto de Santa María (Cádiz) (ES)
(74) Representative: Pons
(86) International application number: PCT/ES2014/070630
(87) International publication number: WO 2015/015041

(56) References cited:
- EP-A1- 2 348 342
- EP-A2- 2 418 692
- DE-A1-102008 026 760
- US-A1- 2006 191 566
- US-A1- 2008 185 033
- US-A1- 2013 167 903

## Description

### Field of the Art

The present invention is comprised in the technical field of renewable energies, more specifically in the field relating to both solar thermal and thermoelectric energy as well as photovoltaic solar energy.

### State of the Art

The most widely available thermal solar panels on the market today are two-dimensional planar structures in which solar radiation is concentrated in the fluid carrying pipes by means of metal fins covered with radiation absorbing paint. Heat dissipation is prevented by means of insulation with rock wool or similar elements, but there are still convection losses that cannot be prevented in this concept. The entire system is comprised within an aluminum frame, and the front surface is sheet glass. The entire assembly is heavy, weighing over 30 kg for a 2 m² panel.

These panels, called planar collectors, are relatively inexpensive and highly efficient for warm climates and moderate increases in heat-carrying fluid temperature, up to 50°C, which limits their application both to regions with said climate and to low fluid heating ranges. If the panel is to be placed in cooler areas or if the fluid is to be heated to higher temperatures (over 100°C and up to 150°C), two other concepts are needed. On one hand, the so-called vacuum tube collectors are needed. In said collectors, the pipe to be heated is introduced in a glass tube where the vacuum is formed, minimizing heat losses due to convection. On the other hand, the so-called compound parabolic collectors, or CPC, are needed, and they concentrate light on the pipes by means of pseudoparabolic mirrors. In addition to being heavy, both concepts have the major drawback of their price, because they require complicated technology and/or materials increasing the price to two or even three times that of the planar collector.

Therefore, it is suitable to develop a product in this field which is highly efficient in different regions and temperature ranges, from 50 to 150°C, while at the same time is much lighter and has a price that is comparable to or less than the price for a planar collector.

As regards photovoltaic solar modules, the most widely available photovoltaic solar modules on the market are planar modules with a glass front, an aluminum frame and virtually the entire surface covered with photovoltaic solar cells. This structure is also heavy, weighing about 20 kg for a conventional 250 W module. Given that solar cells represent by far the most significant part of the cost, there has been a decades-long effort to reduce their surface by replacing them with concentrator elements which are theoretically less expensive and can direct all the light received on them. However, photovoltaic solar concentration systems of many different kinds have failed to successfully penetrate the market up until now. The main reasons are the price as well as the highly complicated final structure of the complete system which requires solar tracking. Furthermore, the concentrations achieved, greater than 20 times the sun, or 20X, and up to 1,000X in high concentration systems usually add another problem: the solar cell heats up excessively, and an active or passive cooling system must be considered. This adds complexity and cost to these systems.

Holography as an optical technology has many advantages with respect to other optical concentrator systems (lenses or mirrors, for example): it is much more versatile and less expensive than optical concentrator systems. It also eliminates the need for solar tracking when used at a low concentration, whereby reducing system complexity.

There have been earlier attempts to use holography in solar panels. Patent US4863224, granted to Afian et al., for example, uses a hologram and a prism or plate. However, this solar concentrator must be aligned with the sun and it does not have any passive tracking capacity. Another invention which also has this drawback is patent US5268985 granted to Ando et al. Said invention comprises a hologram and a total reflection surface, but in addition to requiring tracking, it is constructed for capturing monochromatic light and wastes most of the solar spectrum. Patents US5877874 and US6274860, granted to Rosenberg, discloses a holographic planar concentrator in which at least one multiplexed holographic film, achieving high spectral and angular bandwidths, concentrates the light on solar cells placed in the same plane. This invention has the drawback of having excessive spectral losses and the need for using bifacial cells, as well as the need for placing the entire photovoltaic solar system in a planar location with the ground painted white to reflect the albedo. Patent US20080257400, granted to Mignon and Han, also discloses a holographic planar concentrator but with two different surfaces, in which there are multiplexed transmission and reflection holograms, with the solar cells perpendicular to said collector surfaces. In addition to the losses due to various reflections and transmissions in the various holograms, the main drawback of this design is the difficulty in building it, which can prevent manufacturing it at competitive costs. Patent US20120125403, granted to Orlandi, proposes applying holographic films directly on conventional photovoltaic modules, such that any radiation striking from different angles is used as radiation perpendicular to the plane of the module. Although this concept is highly marketable due to scarce interference in the original design, it does not reduce the weight or the manufacturing cost of current modules. Finally, patent US 2006/191566 A1 discloses a light gathering element comprising a transparent scattering optical medium and a reflective surface, having a dip in performance within the central 20° angles but exhibiting a relatively large acceptance angle (80% efficiency within the central 120° in the best case).

None of the aforementioned inventions aims to reduce panel weight, an important factor for both the cost and mounting difficulty (which also has a bearing on the cost of solar energy as an overall concept). The present invention uses plastic materials that are widely available on the market for constructing the panels. Furthermore, it combines not only one or two, but up to three optical elements for concentration purposes, which significantly increases solar spectrum collection, and it does all this at an industrial production cost which is even less than current conventional panels.

### Description of the Invention

The study of the state of the art shows that the main problem involved in implementing the holography in both thermal and photovoltaic solar applications is collecting as much of the solar spectrum as possible. This refers both to the variation in the angles of incidence throughout the different seasons of the year and the wide range of energetically significant wavelengths which must be collected.

In terms of wavelengths, in order to collect a significant part of the solar spectrum, the hologram must be capable of collecting at least the region between 500 nanometers (nm) and 1,100 nm. This portion contains 70% of all the energy of the solar spectrum. Yet even more ideally, the hologram must be capable of collecting between 400 nm and 1,200 nm, i.e., 80% of the total spectrum. However, current holograms, particularly reflection holograms, are capable of collecting for each diffraction grating a maximum of 300 nm, and this is by means of special processes. Therefore, at least two superposed, i.e., multiplexed, diffraction gratings will be necessary for capturing the required minimum of 70%.

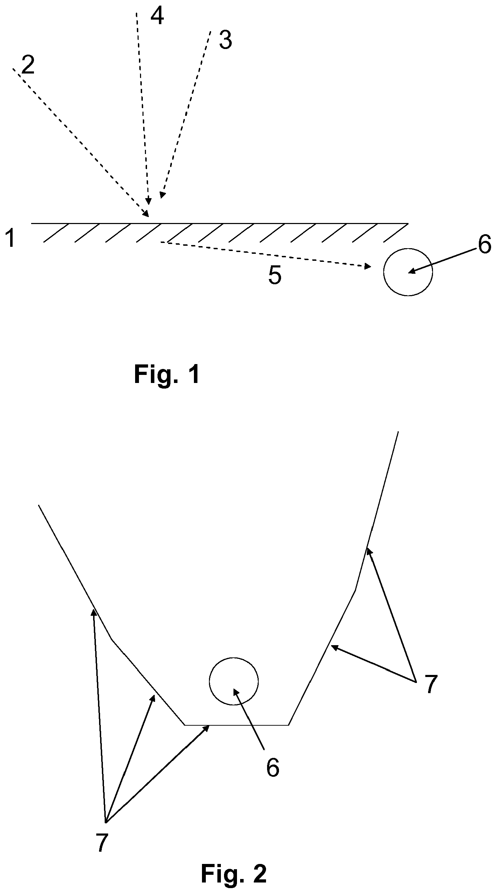

However, those wavelengths must be collected throughout the year, from morning to night. Generally, the annual variation of the angles of incidence of sunlight is kept at about 60° in a wide range of terrestrial latitudes. As seen in Figure 1, a surface (1) tilted at latitude will receive radiation (2) from a smaller angle in winter and radiation (3) from a larger angle in summer. Radiation (4) in spring and fall will be received with an angle very close to the perpendicular. The angular variation between (2) and (3) are about 60° as mentioned. Reflection holograms are capable of capturing a maximum variation of ±15°, so in this case at least two multiplexed diffraction gratings are also necessary. Along with the wavelength requirements, at least four multiplexed gratings are needed. Given that the holographic materials lose efficiency as the number of multiplexed gratings increases, this minimum of four gratings is also the maximum imposed by the physics of the material. In other words, the hologram must not capture less, but it cannot capture more than that mentioned previously either if efficiency loss is to be prevented.

On the other hand, in a planar configuration such as that of Figure 1, there is the additional problem that if the quantity of radiation receivers (depicted in Figure 1 as a pipe (6) in a thermal solar panel) is to be greatly reduced, then the radiation angle of departure (5) must be very steep. This presents a problem in hologram construction: such steep angles cannot be obtained in a commercially viable manner without excessive optical losses in the hologram, particularly due to Fresnel reflection. Such reflection occurs in any optical surface, and the larger the angle of incidence with respect to the normal, the greater such reflection.

It is obvious that a planar solar panel configuration, particularly a planar capture by the hologram, as presented in most of the solutions mentioned in the state of the art, is insufficient and will always lead to limited performances.

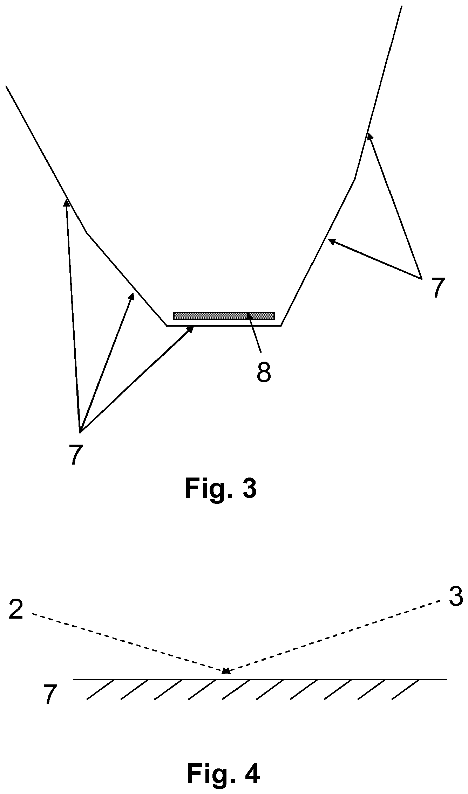

For this reason, the present invention proposes as a solution a thermal or photovoltaic solar panel as defined in claim 1. An embodiment of the invention comprises a three-dimensional structure repeated several times, the 3D unitary structure of which can be observed in a front section view in Figure 2 for the case of a thermal solar panel. In said figure, the radiation receiver (6) is a pipe, for example a copper pipe, located in the center of a pseudoparabolic structure formed by several planes or curves (7) each having a different tilt with respect to one another. Figure 3, which is equivalent to Figure 2, depicts the photovoltaic solar module where the radiation receiver (8) is in this case a photovoltaic solar cell housed at the bottom of the 3D unitary structure.

A system in which the radiation receivers (6) or (8) can be substantially reduced is thus obtained. In other words, the distance between pipes in a thermal solar panel and the distance between branches of solar cells in a photovoltaic solar module can be greater. It must be pointed out that the 3D unitary structure is asymmetrical because the angles of incidence of solar radiation (2) and (3) are different in winter and summer if the panel is tilted at latitude.

As seen in Figure 4, the only drawback of this configuration is that if the different planes or curves (7) are projected on the plane tilted at latitude, the variation in the angles of incidence between radiation in winter (2) and radiation in summer (3) increases substantially, from the mentioned 60° to more than 150°. It is no longer possible to capture the entire angular variation with two multiplexed diffraction gratings (70% of the spectral bandwidth, however, can still be captured by means of the two wavelength diffraction gratings described above).

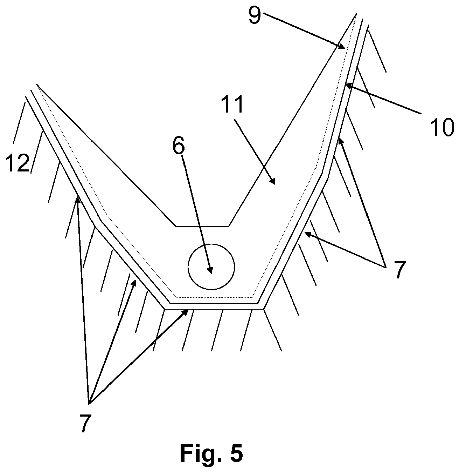

Due to the inability to capture the entire angular variation, the present invention incorporates not only reflection holograms (9) as a concentrating optical element (see Figure 5, always in front section view), but also two more elements. One of them is a highly reflective surface (10) which can even have an insulating part, such as the insulation foils used in construction. The other element is a transparent optical medium (11) having high optical quality, such as a silicone or transparent polyurethane, for example. This medium must have a refractive index n close to the refractive index of the holographic material, such that there is no difference due to a change in medium as the radiation goes from one medium to another.

The 3D unitary structure of the panel is defined as follows (see Figure 5):
- a polymeric or plastic base (12) containing therein the planes or curves (7) providing the pseudoparabolic shape of the 3D unitary structure of the panel,
- a highly reflective surface (10) placed on this polymeric or plastic base (12), inside the 3D unitary structure of the panel,
- a reflection hologram with several multiplexed diffraction gratings (9) which is placed on the highly reflective surface (10),
- radiation receivers which are either pipes (6) or solar cells (8), and
- a transparent optical medium (11) sealing the inside of the 3D unitary structure.

Therefore, the three optical elements are combined and work in the following manner to capture the entire 150° of variation in the angles of incidence:
a.) The reflection hologram (9) captures up to about the central 60°. It is constructed such that the beam reflected by diffraction leaves the hologram with an angle greater than the critical angle of the medium (11) (see below)
b.) The highly reflective surface (10) captures greater angles, about a range of 20° above each side of the central 60°. In other words, with both elements, i.e., the hologram (9) and the reflective surface (10), at least one variation in the angle of incidence of 100° can be captured. By reflecting towards the medium (11) with the same angle of departure, it is assured that within the medium (11) there is an angle greater than the critical angle (see below), and
c.) The medium (11) has a dual purpose: on one hand, it captures radiation striking with angles greater than the central 100° and reflects them by Fresnel reflection, directing them towards another plane or curve (7) of the plastic base (12), where it has already been captured by either the hologram (9) or the reflective surface (10). On the other hand, the medium (11) is constructed with an angle not parallel to and greater than the planes or curves (7) (see the next paragraph).

Therefore, it is assured that in the medium (11) all the radiation returned either as a result of being diffracted from the hologram (9) or reflected from the reflective surface (10) does not leave the medium, since it strikes its inner surface with an angle greater than the critical angle. The radiation is therefore returned through total internal reflection (TIR) to within the medium (11), where either the hologram (9) or the reflective surface (10) will work again successively until reaching the radiation receiver (6) (pipes for a thermal solar panel) or (8) (photovoltaic solar cells for a photovoltaic solar module). The TIR has 100% efficiency, so there are no losses in it. As regards the hologram (9) or the highly reflective surface (10), efficiencies exceed 95% and even 98%, whereby minimizing losses in each diffraction or reflection. Furthermore, the 3D unitary structure is designed so that the maximum number of diffractions and/or reflections until reaching the radiation receiver (6) or (8) is not more than three, so losses are even lower.

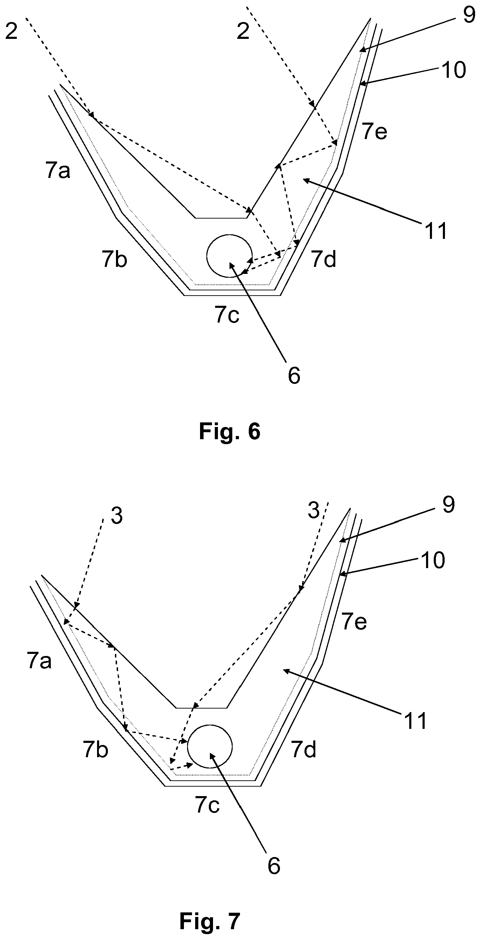

To better explain these effects, Figures 6 to 8 depict different times of the year with different angles of incidence. In a non-exclusive configuration, there are five planes (7) referred to as (7a) to (7e), each having a different tilt.

In Figure 6, early morning radiation in winter (2) hits the planes or curves (7a) and (7b) with a very steep angle. Fresnel reflection will occur mainly in those planes, sending radiation to the planes or curves (7d) or (7e). Upon entering the medium (11), the radiation refracts with the corresponding angle. Depending on that angle of arrival, the radiation will be captured by either the hologram (9) or the reflective surface (10). Upon being diffracted or reflected, respectively, the radiation runs through the medium (11) with an angle greater than the critical angle, so upon reaching the medium-air interface, total internal reflection (TIR) will occur, sending the radiation again to within the medium, and several diffractions and/or reflections (maximum 3) occur successively, until reaching the radiation receiver (6) or (8) (the figure shows the example of a thermal solar panel, the radiation receiver of which is a pipe (6)).

In Figure 7, mid-day radiation in summer (3) hits the planes or curves (7d) and (7e) with a very steep angle. Fresnel reflection will occur mainly in those planes, sending radiation to the planes or curves (7a) or (7b). Upon entering the medium (11), the radiation refracts with the corresponding angle. Depending on the angle of arrival, the radiation will be captured by either the hologram (9) or the reflective surface (10). Upon being diffracted or reflected, respectively, the radiation runs through the medium (11) with an angle greater than the critical angle, so upon reaching the medium-air interface, total internal reflection (TIR) will occur, sending the radiation again to within the medium, and several diffractions and/or reflections (maximum 3) occur successively, until reaching the radiation receiver (6) or (8) (the figure shows the example of a thermal solar panel, the radiation receiver of which is a pipe (6)).

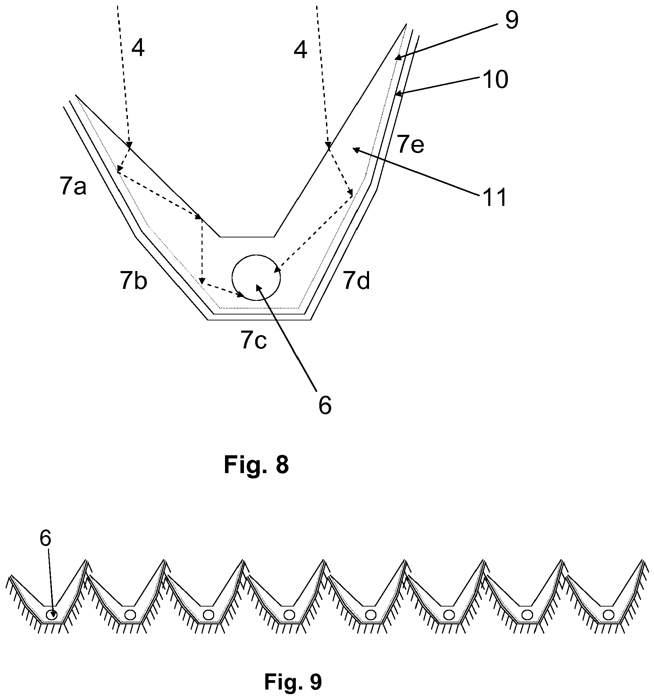

In Figure 8, radiation in spring or fall (4) enters the medium (11) and refracts with the corresponding angle. Depending on the angle of arrival, the radiation will be captured by either the hologram (9) or the reflective surface (10). Upon being diffracted or reflected, respectively, the radiation runs through the medium (11) with an angle greater than the critical angle, so upon reaching the medium-air interface, total internal reflection (TIR) will occur, sending the radiation again to within the medium, and several diffractions and/or reflections (maximum 3) occur successively, until reaching the radiation receiver (6) or (8) (the figure shows the example of a thermal solar panel, the radiation receiver of which is a pipe (6)).

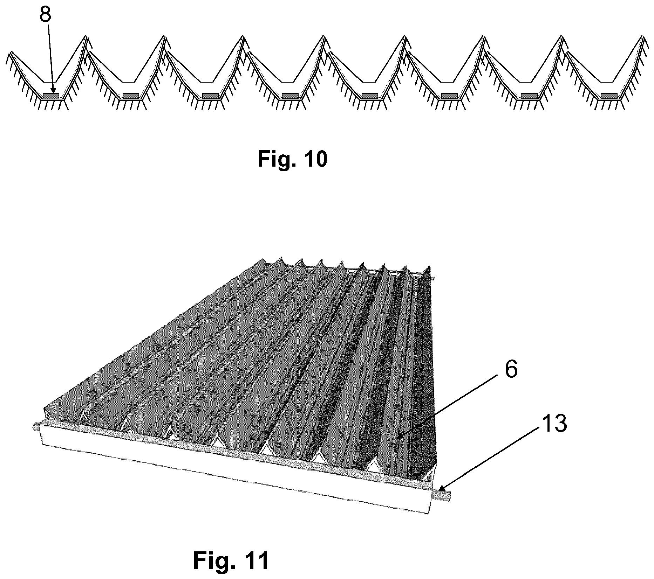

In this manner, the mentioned 3D unitary structure thus captures radiation during every season of the year and very efficiently directs it to the radiation receiver (6) or (8). A thermal solar panel or a photovoltaic solar module having a power that is equivalent to those available on the market today (se Figures 9 and 10, respectively) is obtained by joining several, for example, 8 to 10 of these 3D unitary structures together. The asymmetry of the 3D unitary structure means that both the left and right sides are not at the same height. However, shading losses are reduced in the early morning in winter and do not reach a yearly total of 3%.

Both the base (12) made of an environmentally resistant polymeric material resistant and the medium (11) made of an environmentally resistant optical polymeric material (silicone or polyurethane, for example) can be extruded by means of plastic molding. They assure rigidity, thereby making a frame unnecessary, as well as a significant weight reduction. On the other hand, since the base (12) is made by extrusion from a mold, it can include in the same extrusion all the anchoring elements necessary for fixing the panels to the mounting structures of any photovoltaic solar system. It can also include, for example, in the case of a thermal solar panel, the openings or cavities necessary for housing at the ends of the panel the collector pipes (13) having a larger diameter (see Figure 11). In a photovoltaic solar module, it will also include the openings necessary to make all kinds of electric connections between cells.

It must be mentioned that there is a fundamental difference between a thermal solar panel and a photovoltaic solar module affecting the present design: in a thermal solar panel, it is of interest to retain heat inside the structure to minimize losses and assure heating of the heat-carrying fluid (referring to losses due to conduction, since losses due to convection are insignificant as the pipes are completely imbued in a solid medium). In a photovoltaic solar module, however, as much heat as possible should be dissipated since the efficiency of the solar cells decreases with the temperature thereof.

In the present design, this difference is resolved by choosing different plastic materials both for the plastic base (12) and for the medium (11), which are in any case environmentally resistant. Specifically, for a thermal solar panel, plastic materials with very low thermal conductivity K, for example around 0.02-0.03 W·m⁻¹·K⁻¹, are of interest. For a photovoltaic solar module, the reverse is applicable. Therefore, for photovoltaic solar modules, the plastic materials making up both the plastic base (12) and the medium (11) must have thermal conductivity greater than 0.05 W·m⁻¹·K⁻¹, for example, and even greater than 0.07 W·m⁻¹·K⁻¹.

### Description of the Drawings

Figure 1 shows the variation in the angles of incident solar radiation between winter (2) and summer (3) on a surface (1) tilted at latitude. Early morning solar radiation in winter (2) strikes the surface (1) with a smaller angle, whereas mid-day solar radiation in summer (3) strikes that same surface (1) with a larger angle. The difference between both angles is about 60° for many latitudes. Radiation in spring or fall (4) strikes said surface (1) in a virtually perpendicular manner. If said radiation is to strike radiation receivers (6) spaced far enough away from one another so as to make a thermal solar panel or photovoltaic solar module economically viable, then the radiation angle of departure (5) must be very steep, which is very expensive and complicated in current holographic technology.
Figure 2 shows a front section view of the 3D unitary structure of the proposed thermal solar panel. Several planes or curves (7) each having a different tilt with respect to one another form a pseudoparabolic structure, the center of which is occupied by the radiation receiver, in this case a pipe (6).
Figure 3 shows a front section view of the 3D unitary structure of the proposed photovoltaic solar module. Several planes or curves (7) each having a different tilt with respect to one another form a pseudoparabolic structure, the bottom of which is occupied by the radiation receiver, in this case photovoltaic solar cells (8).
Figure 4 shows a depiction of the variation in incident radiation angle between winter (2) and summer (3), if the different planes or curves (7) are projected on the plane tilted at latitude. This variation in angles exceeds 150°.
Figure 5 shows a front section view of the 3D unitary structure of the solar panel (in this case, a thermal solar panel) with the different elements making up same: a plastic base (12) the inner surface of which is made up of the planes or curves (7) each having a different tilt with respect to one another; a highly reflective surface (10) covering said planes or curves (7); a reflection hologram (9) with several multiplexed diffraction gratings covering the reflective surface (10), and a transparent optical medium (11) sealing the entire assembly. The radiation receiver, in this case a pipe (6), is arranged therein.
Figure 6 shows the optical path of early morning incident radiation in winter (2) as it reaches the 3D unitary structure of the solar panel (in this case a thermal solar panel). Said radiation (2) is reflected in the planes (7a) and (7b) by Fresnel reflection directly on the surface of the medium (11), towards the planes (7d) or (7e). Upon reaching the medium (11) therein, it refracts with the corresponding angle and hits the reflection hologram (9) or the highly reflective surface (10). The latter diffract or reflect the radiation, respectively, towards the medium (11) again with an angle greater than the critical angle, such that TIR occurs within the medium. Successive diffractions and/or reflections lead the radiation towards the radiation receiver (in this case a pipe (6)).
Figure 7 shows the optical path of mid-day incident radiation in summer (3) as it reaches the 3D unitary structure of the solar panel (in this case a thermal solar panel). Said radiation (3) is reflected in the planes or curves (7d) and (7e) by Fresnel reflection directly on the surface of the medium (11), towards the planes or curves (7a) or (7b). Upon reaching the medium (11) therein, it refracts with the corresponding angle and hits the reflection hologram (9) or the highly reflective surface (10). The latter diffract or reflect the radiation, respectively, towards the medium (11) again with an angle greater than the critical angle, such that TIR occurs within the medium. Successive diffractions and/or reflections lead the radiation towards the radiation receiver (in this case a pipe (6)).
Figure 8 shows the optical path of incident radiation in spring or fall (4) as it reaches the 3D unitary structure of the solar panel (in this case a thermal solar panel). In all the planes or curves (7a) to (7e), upon reaching the medium (11), it refracts with the corresponding angle and hits the reflection hologram (9) or the highly reflective surface (10). The latter diffract or reflect the radiation, respectively, towards the medium (11) again with an angle greater than the critical angle, such that TIR occurs within the medium. Successive diffractions and/or reflections lead the radiation towards the radiation receiver (in this case a pipe (6)).
Figure 9 shows a front section view of a complete thermal solar panel made up of several 3D unitary structures (in this case eight). The radiation receiver in a thermal solar panel consists of pipes (6).
Figure 10 shows a front section view of a complete photovoltaic solar module made up of several 3D unitary structures (in this case eight). The radiation receiver in a photovoltaic solar module consists of photovoltaic solar cells (8).
Figure 11 shows a possible non-exclusive embodiment of a thermal solar panel. Eight 3D unitary structures include eight pipes (6) having an outer diameter of 8 mm, for example, welded to two collector pipes (13) having a larger diameter, for example, 18 mm.

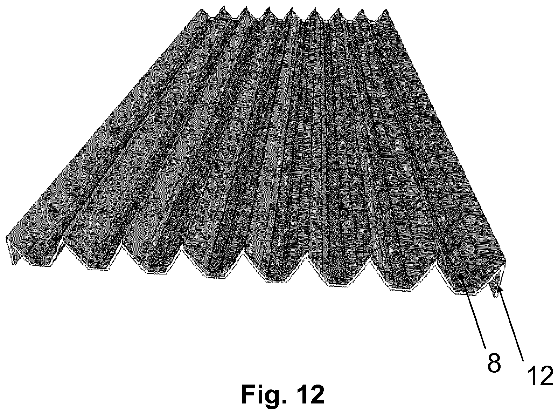

Figure 12 shows a possible non-exclusive embodiment of a photovoltaic solar module. Eight 3D unitary structures include eight branches of photovoltaic cells (8) of 31 x125 mm each, for example. The connection between them is very versatile due to openings in the plastic base (12) allowing any kind of connection between cells.

### Embodiments of the Invention

In a preferred but non-exclusive configuration, both the thermal solar panel and the photovoltaic solar panel will consist of eight 3D unitary structures as described in Figures 2 to 10. The dimensions of said structures will be about 80 mm in height by 120 mm in width and a length of 1.5 meters. Therefore, the solar panel will have dimensions of about 1,500x1,000x80 mm, i.e., very close to the magnitudes of any standard panel. Both the plastic base (12) and the covering and sealing medium (11) are made of environmentally resistant plastic materials, and furthermore the base can adapt to any shape, whereby reducing material used, and the total weight can be reduced to more than half the weight of a standard commercial panel.

Since the plastic base (12) can be made in a mold, it can include all the necessary elements, including anchors for the mounting system or openings for versatile connection of the photovoltaic solar cells, both in series and in parallel. Likewise, for the case of a thermal solar panel, said plastic base (12) can be made with the necessary extensions for resistant to the elements taking in the collector pipes (13) (see Figure 11).

In the case of a thermal solar panel, the radiation receivers are pipes (6). In the described embodiment, they can be copper pipes having an outer diameter of 8 mm. The collector pipes (13) have a larger diameter, for example, 18 mm. Since there is a total number of eight pipes (6), the fluid heating capacity achieved is similar to that of a conventional planar collector. However, the efficiency thereof will be improved for heating fluids at high temperatures because sealing with the medium (11) minimizes losses due to convection. Furthermore, construction with materials having low thermal conductivity also significantly reduces losses due to conduction.

The photovoltaic solar module in this embodiment can consist of an array of 120 cells of 31x125 mm, attached in eight branches of 15 cells each. The complete module will therefore have dimensions of about 1,800x1,000x80 mm. If conventional cells having 17% efficiency are used, this configuration obtains a module having a rated power of about 250 W. To obtain the same electrical parameters as a conventional photovoltaic module of the same power, the connection must be made with four branches in parallel, connected in series with the next four branches.

## Claims

1. Thermal or photovoltaic solar panel comprising:
a polymeric base (12) with one or several unitary cavities, which are composed by a pseudo-parabolic structure formed by planes or curves (7), each having a different tilt with respect to one another, which facilitates a wave-guiding effect through Total Internal Reflection (TIR) in combination with the following optical elements;
- a highly reflective surface (10) covering the inside of these cavities;
- a reflection hologram with several multiplexed diffraction gratings (9) in turn covering the highly reflective surface (10);
- a transparent optical medium (11) with refractive index n similar to that of the holographic material (9), covering and sealing the entire assembly; and
- a radiation receiver, which is either pipes (6) located in the center of said pseudo-parabolic structure and arranged within the transparent optical medium in the case of a thermal solar panel, or photovoltaic solar cells (8) housed at the bottom of the cavity in the case of a photovoltaic solar module;
wherein
- said reflection hologram (9) is configured to capture radiation impinging on each plane up to about the central 60°, that is, 30° at both sides of each plane's normal, and to diffract it with angles of departure greater than the critical angle of said medium (11) with air;
- said highly reflective surface (10) is configured to capture about a range of 20° above each side of said central 60°;
- said transparent optical medium (11) is configured to capture radiation striking with angles greater than the central 100° and reflect them by Fresnel reflection on the interface of said medium (11) with air towards another plane or curve (7) of said polymeric base (12); and
- said transparent optical medium (11) has an outer surface which is not parallel to the planes or curves (7) and has a tilt angle that is larger than and different from that of the planes and the curves (7) such that both the radiation diffracted by said hologram (9) and the radiation reflected by said highly reflective surface (10) are redirected to said medium (11) with an angle greater than the critical angle of the medium with air, such that said radiation is captured in said medium (11) by Total Internal Reflection (TIR).

2. Thermal or photovoltaic solar panel according to claim 1, **characterized in that** both the polymeric base (12) and the transparent optical medium (11) are made of polymeric materials having a thermal conductivity of approximately 0.02-0.03 W·m·K⁻¹ in the case of thermal solar panels, and thermal conductivity higher than approximately 0.05 W·m·K⁻¹ in the case of photovoltaic solar modules, thereby assuring heat retention and dissipation due to conduction, respectively.

## Patentansprüche

1. Wärme- oder Photovoltaiksolarpaneel umfassend:
eine Polymerbasis (12) mit einem oder mehreren einheitlichen Hohlräumen, welche aus einer pseudoparabelförmigen Struktur bestehen, die durch Ebenen oder Kurven (7) gebildet ist, die jeweils eine andere Neigung zueinander aufweisen, was einen Wellenleiteffekt durch interne Totalreflektion (TIR) in Kombination mit folgenden optischen Elementen ermöglicht;
- eine hochreflektive Fläche (10), die das Innere dieser Hohlräume abdeckt;
- ein Reflektionshologramm mit mehreren gemultiplexten Brechungsgittern (9), die wiederum die hochreflektive Fläche (10) abdecken;
- ein transparentes optisches Medium (11) mit einem Brechungsindex n, der ähnlich ist wie jener des holographischen Materials (9), das die gesamte Anordnung abdeckt und abdichtet; und
- einen Strahlungsempfänger, welcher entweder Rohre (6), die im Mittelpunkt der pseudoparabelförmigen Struktur liegen und innerhalb des transparenten optischen Mediums im Falle eines Wärmesolarpaneels angeordnet sind, oder Photovoltaiksolarzellen (8), die auf der Unterseite des Hohlraums im Falle eines Photovoltaiksolarmoduls aufgenommen sind, ist; wobei
- das Reflektionshologramm (9) ausgebildet ist, um Strahlung zu erfassen, die auf jede Ebene bis zu ungefähr den zentralen 60 °, d. h. 30 ° auf beiden Seiten der Senkrechten von jeder Ebene, auftrifft, und diese mit größeren Öffnungswinkeln als der kritische Winkel des Mediums (11) mit Luft zu brechen;
- die hochreflektive Fläche (10) ausgebildet ist, um ungefähr einen Bereich von 20 ° oberhalb von jeder Seite der zentralen 60 ° zu erfassen;
- das transparente optische Medium (11) ausgebildet ist, um Strahlung zu erfassen, die mit Winkeln, die größer als die zentralen 100° sind, zu erfassen und diese durch Fresnel-Reflektion auf der Schnittstelle des Mediums (11) mit Luft zu einer anderen Ebene oder Kurve (7) der Polymerbasis (12) zu reflektieren; und
- das transparente optische Medium (11) eine äußere Fläche aufweist, welche zu den Ebenen oder Kurven (7) nicht parallel ist und einen Neigungswinkel aufweist, der größer als jener der Ebenen und der Kurven (7) ist und sich von diesem unterscheidet, so dass sowohl die Strahlung, die von dem Hologramm (9) gebrochen wird, als auch die Strahlung, die von der hochreflektiven Fläche (10) reflektiert wird, zu dem Medium (11) mit einem Winkel, der größer als der kritische Winkel des Mediums mit Luft ist, weitergeleitet wird, so dass die Strahlung in dem Medium (11) durch interne Totalreflektion (TIR) erfasst wird.

2. Wärme- oder Photovoltaiksolarpaneel nach Anspruch 1,
**dadurch gekennzeichnet, dass** sowohl die Polymerbasis (12) als auch das transparente optische Medium (11) aus Polymermaterialien hergestellt sind, die eine Wärmeleitfähigkeit von ungefähr 0,02 - 0,03 W*m*K⁻¹ im Falle von Wärmesolarpaneelen und eine Wärmeleitfähigkeit, die höher als ungefähr 0,05 W*m*K⁻¹ im Falle von Photovoltaiksolarmodulen ist, aufweisen, wodurch jeweils eine Wärmerückhaltung und -abgabe aufgrund der Leitung sichergestellt wird.

## Revendications

1. Panneau solaire thermique ou photovoltaïque comprenant :
une base polymérique (12) avec une ou plusieurs cavités unitaires, qui sont composées d'une structure pseudo-parabolique formée par des plans ou courbes (7), chacun ayant une inclinaison différente l'un par rapport à l'autre, qui permet un effet de guide d'ondes à travers la Réflexion Totale Interne (RTI) conjointement aux éléments optiques suivants ;
- une surface hautement réfléchissante (10) recouvrant l'intérieur de ces cavités ;
- un hologramme de réflexion avec plusieurs grilles de diffraction multiplexées (9) recouvrant à leur tour la surface hautement réfléchissante (10) ;
- un milieu optique transparent (11) avec un indice de réfraction n similaire à celui du matériau holographique (9), recouvrant et scellant tout l'assemblage ; et
- un récepteur de rayonnement, qui est soit des tubes (6) situés au centre de ladite structure pseudo-parabolique et disposés dans le milieu optique transparent dans le cas d'un panneau solaire thermique, soit des cellules solaires photovoltaïques (8) logées sur la partie inférieure de la cavité dans le cas d'un module solaire photovoltaïque ;
dans lequel
- ledit hologramme de réflexion (9) est configuré pour capturer le rayonnement ayant une incidence sur chaque plan environ jusqu'à la centrale 60°, autrement dit, 30° sur les deux côtés de la normale de chaque plan, et pour le diffracter avec des angles de départ supérieurs à l'angle critique dudit milieu (11) avec l'air ;
- ladite surface hautement réfléchissante (10) est configurée pour capturer environ une plage de 20° au-dessus de chaque côté de ladite centrale 60° ;
- ledit milieu optique transparent (11) est configuré pour capturer le rayonnement frappant avec des angles supérieurs à la centrale 100° et les réfléchir par réflexion Fresnel sur l'interface dudit milieu (11) avec l'air vers un autre plan ou courbe (7) de ladite base polymérique (12) ; et
- ledit milieu optique transparent (11) a une surface externe qui n'est pas parallèle aux plans ou courbes (7) et a un angle d'inclinaison qui est plus large que et différent de celui des plans et des courbes (7) de sorte que le rayonnement diffracté par ledit hologramme (9) et le rayonnement réfléchi par ladite surface hautement réfléchissante (10) sont tous les deux redirigés vers ledit milieu (11) avec un angle supérieur à l'angle critique du milieu avec l'air, de sorte que ledit rayonnement est capturé dans ledit milieu (11) par Réflexion Totale Interne (RTI).

2. Panneau solaire thermique ou photovoltaïque selon la revendication 1, **caractérisé en ce que** la base polymérique (12) et le milieu optique transparent (11) sont tous les deux faits dans des matériaux polymériques ayant une conductivité thermique approximativement de 0,02-0,03 W·m·K⁻¹ dans le cas des panneaux solaires thermiques, et une conductivité thermique supérieure à approximativement 0,05 W·m·K⁻¹ dans le cas des modules solaires photovoltaïques, assurant ainsi une rétention et une dissipation de la chaleur dues à la conduction, respectivement.
